# EUROPEAN PATENT APPLICATION

(11) **EP 2 045 468 A1**
(43) Date of publication of application: **08.04.2009**
(21) Application number: 07791272.3
(22) Date of filing: 25.07.2007
(51) Int. Cl.: F04B 43/04, F04B 43/02

(54) **DIAPHRAGM PUMP**

(30) Priority: 25.07.2006 JP 2006201439
(71) Applicant: Panasonic Electric Works Co., Ltd, Kadoma-shi Osaka 571-8686 (JP)
(72) Inventor: KITAHARA, Harunori, Kadoma-shi Osaka 571-8686 (JP); HOJO, Tsukasa, Kadoma-shi Osaka 571-8686 (JP)
(74) Representative: Mackenzie, Andrew Bryan
(86) International application number: PCT/JP2007/064556
(87) International publication number: WO 2008/013191

(57) **Abstract**

In a diaphragm pump performing electrostatic atomization, occurrence of defects such as electrolysis of liquid is restricted and enables to electrostatic atomization smoothly. The diaphragm pump 10 comprises a pump chamber unit 1 and a diaphragm unit 2, and the diaphragm unit 2 has a diaphragm driving portion 2a by a piezoelectric element 21 and a driving power transmission portion 2b to transmit variation of the driving portion 2a to a pump chamber portion 3. The pump chamber unit 1 comprises a pump chamber 31 formed of an electric conductive material, a liquid container 4, a suction flow path 34a coupling the liquid container 4 and the pump chamber 31, a discharge vent 5 from which the liquid is discharged, and a discharge flow path 34b coupling the discharge vent 5 and the pump chamber 31, and the pump chamber 31 has a driven membrane 33a which is cooperated with the driving power transmission portion 2b and formed of an electric conductive resin. Thereby, flow paths 37 of the liquid can be made the same electric potential, and defects such as isolation of liquid due to internal electric field or generation of gas due to electrolysis can be prevented, and electrostatic atomization can be performed smoothly.

## Description

### Technical Field

The present invention relates to a diaphragm pump which is driven by a diaphragm using a piezoelectric element and supplies liquid for electrostatic atomization.

### Background Art

In such kind of conventional diaphragm pump, an electrostatic voltage is usually applied between a discharge vent from which liquid is discharged and a ground (earth) for electrostatic atomization. However, if the electrostatic voltage is too high voltage (or too low voltage), different potential portions may occur at points where liquid in a flow path contacts so that electrolysis may occur partially in the flow path, and thus, defects such as isolation of liquid solute or generation of gas may occur.

By the way, as described in Publication Gazette of Japanese Utility Model Application 2-69079, for example, a piezoelectric pump, which consists of a pump actuator unit and a pump coupling unit which is detachably attached to the pump actuator unit, is proposed as the diaphragm pump.

However, since the pump coupling diaphragm is formed of an insulation resin, when a voltage is applied thereto for electrostatic atomization, potential of a pump chamber becomes uneven entirely, so that the potential of the liquid cannot be even. Therefore, the defect such as electrolysis may occur, and thus, electrostatic atomization cannot be performed smoothly.

On the other hand, as described in Publication Gazette of Japanese Patent Application 2005-98263, a pump is proposed to comprise a pump chamber which can vary a capacity thereof by a diaphragm and an actuator unit for driving the diaphragm, and wherein the pump chamber and the actuator unit are formed of a metallic powder or stainless steel, and the pump chamber and the actuator unit are detachably attached. Alternatively, as described in Publication Gazette of Japanese patent Publication 63-176679, a piezoelectric pump is proposed to have a diaphragm which is connected to a driving portion of a piezoelectric element, and a pump chamber which is driven by the diaphragm, and wherein the diaphragm and the pump chamber are integrally formed of a stainless steel or a copper.

However, since a liquid container which supplies the liquid to the pump chamber, a discharge portion from which the liquid is discharged, and each flow path to those are not necessarily configured of electric conductive materials, when a voltage is applied for electrostatic atomization, whole of the flow path from the liquid container to the discharge portion cannot become the same potential evenly, so that defects may occur similar to the above mentioned piezoelectric pump described in the Publication Gazette of Japanese Utility Model Application 2-69079.

### Disclosure of Invention

In order to solve the above mentioned problems, a purpose of the present invention is to provide a diaphragm pump which can electrostatically atomize liquid smoothly by removing unevenness of electric potential in surrounding areas of the liquid in flow paths and by reducing occurrence of defects such as deterioration of the liquid to be discharged due to electrolysis, or the like.

### Means to solve the Problems

In order to achieve the above mentioned purpose, the present invention is a diaphragm pump for transferring liquid to electrostatically atomize the liquid, comprising a piezoelectric element, a diaphragm which is deformed by the piezoelectric element, and a pump chamber that varies a capacity thereof in conjunction with the diaphragm and performs suction and discharge of the liquid due to variation of the capacity, wherein the diaphragm and the pump chamber are detachably attached each other; the diaphragm comprises a driving power transmission portion to transmit deformation of the piezoelectric element to the pump chamber; the pump chamber comprises a driven membrane which is in conjunction with the driving power transmission portion, a liquid container which is deformed via the driven membrane and supplies the liquid to the pump chamber, a first flow path which couples the liquid container and the pump chamber, a discharge vent from which the liquid from the liquid container is discharged, and a second flow path which couples the discharge vent and the pump chamber; and when the diaphragm and the pump unit are coupled, at least the liquid container, the first flow path, the pump chamber, the second flow path and the discharge vent are electrically connected to be the same potential.

According to such a configuration, since the surrounding areas of the liquid which flows in the substantially entire path from the liquid container to the discharge vent through the pump chamber can be made the same potential, defects in the liquid flow such as liquid isolation due to internal electric field which occurs when electric potential difference exists in the flow paths or generation of gas due to electrolysis may not occur, and thus, the liquid to be discharged can be electrostatically atomized smoothly without causing reduction of pump performance. In addition, since the pump chamber and the diaphragm are detachable, it is possible to interchange the pump chamber when the pump performance is reduced due to pollution by the liquid.

In the above mentioned improved invention, it is preferable that a surface in the driving power transmission portion which contacts the driven membrane is coated by an electric conductive material, and the driven membrane is formed of a resin film.

According to such a configuration, since the driven membrane is formed of the resin, even when the liquid in the pump chamber has corrosion for metal, the driven membrane is rarely affected by the corrosion, and thus, reliability of the pump chamber can be increased.

In the above mentioned improved invention, it is preferable that the driven membrane has a lamination of a resin film and an electric conductive film which are appressed each other.

According to such a configuration, mechanical strength of the driven membrane is increased due to multi-layered film structure, and consequently, a thing much thinner can be used as the electric conductive material, so that driven performance of the driven membrane can be increased and the transmission efficiency of the driving power can be increased. In addition, when the liquid is corrosive one, the resin film side of the driven membrane can be disposed in the inside of the pump chamber which contacts the liquid so as not to be affected by the corrosion. Moreover, a ready-made two-layered film of the resin film and the metal foil can be used, so that cost reduction can be achieved.

### Brief Description of Drawings

FIG. 1 is an exploded sectional view showing a configuration of a diaphragm pump in accordance with a first embodiment of the present invention.
FIG. 2 is a sectional view showing an entire configuration of the above diaphragm pump.
FIG. 3(a) is a sectional view showing a discharge process of the above pump; FIG. 3(b) is a sectional view showing a suction process of the above pump; FIG. 3(c) is a diagram showing a motion of a piezoelectric element used in the above pump when applying positive voltage; and FIG. 3(d) is a diagram when applying negative voltage to the piezoelectric element.
FIG. 4(a) is an exploded sectional view showing a configuration of a diaphragm pump in accordance with a second embodiment of the present invention; and FIG. 4(b) is a sectional view showing an entire configuration of the same.
FIG. 5(a) is an exploded sectional view showing a configuration of a diaphragm pump in accordance with a third embodiment of the present invention; and FIG. 5(b) is a sectional view showing an entire configuration of the same.

### Best Mode for Carrying Out the Invention

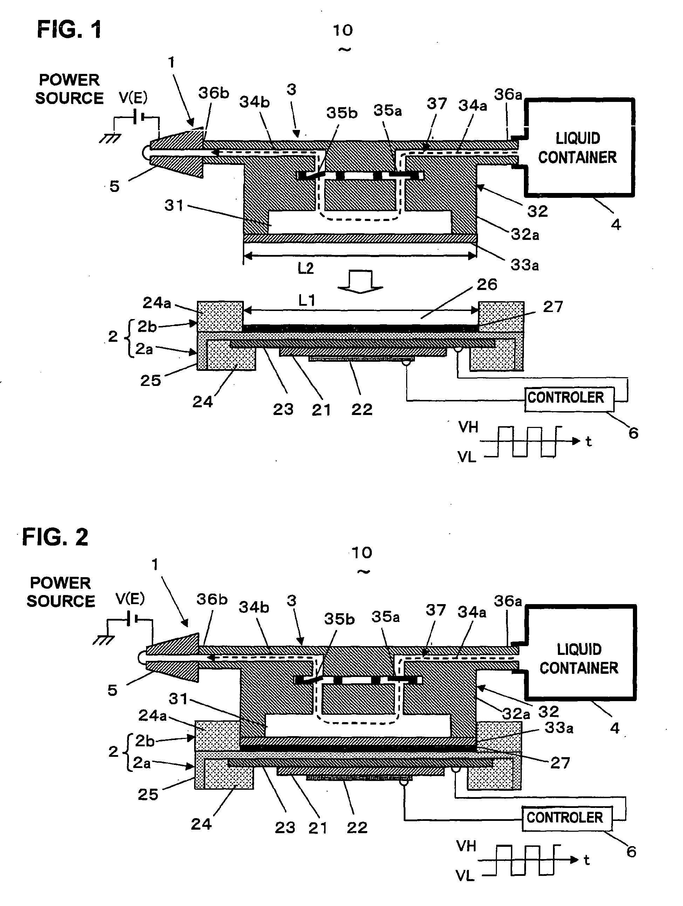

A diaphragm pump in accordance with a first embodiment of the present invention is described with reference to figures. FIG. 1 is an exploded sectional view showing a configuration of the diaphragm pump in accordance with this embodiment, and FIG. 2 is a sectional view showing an integrated entire configuration of the same. In these figures, the diaphragm pump 10 comprises a freely detachable pump chamber unit 1, and a diaphragm unit 2 that drives the pump chamber unit 1. The pump chamber unit 1 has a pump chamber portion 3 which varies a capacity thereof in conjunction with driving of the diaphragm, a liquid container 4 for containing liquid to be supplied to the pump chamber portion 3, and a discharge vent 5 from which liquid is discharged. The diaphragm unit 2 comprises a diaphragm driving portion 2a for driving the diaphragm due to deformation of a piezoelectric element 21 by applying controlling voltages, and a driving power transmission portion 2b for transmitting variation of the diaphragm driving portion 2a to the pump chamber portion 3.

In the pump chamber unit 1, the pump chamber portion 3 has a pump chamber 31 into which liquid is sucked and from which the liquid is discharged, the liquid container 4 for supplying the liquid to the pump chamber 31 (SIC), a suction flow path (first flow path) 34a that couples the liquid container 4 and the pump chamber 31, a discharge vent 5 from which the liquid from the pump chamber 31 is discharged, and a discharge flow path (second flow path) 34b that couples the discharge vent 5 and the pump chamber 31. In addition, an electric power source for applying electrostatic voltage E is connected between a member for sectioning the discharge vent 5 and an earth. Moreover, the suction flow path 34a is connected to the liquid container 4 at a suction opening 36a, and a suction valve 35a for controlling suction rate of liquid into the pump chamber 31 is provided in the vicinity of the pump chamber 31. Similarly, the discharge flow path 34b is connected to the discharge vent 5 at a discharge opening 36b, and a discharge valve 35b for controlling discharge rate of liquid from the pump chamber 31 is provided in the vicinity of the pump chamber 31. These suction flow path 34a, the pump chamber 31, and the discharge flow path 34b are formed in a housing 32 made of an electric conductive material. The pump chamber 31 in the housing 32 is a tubular shaped cavity that a bottom face facing the diaphragm unit 2 is opened, and the opened bottom face is covered by a driven membrane 33a which is made of a thin electric conductive resin film. The driven membrane 33a is connected to the bottom face of the pump chamber 31 by welding such as ultrasonic joining so as to seal the pump chamber 31 and is electrically connected to the bottom face of the pump chamber 31 so that the bottom face and the entire of the pump chamber 31 become the same potential.

In addition, a circumference portion 32a which serves as an outer wall of the pump chamber 31 is formed to have an outer diameter L2 which is substantially the same as an inner diameter L1 of a hollow portion 26 of a housing 24a of the diaphragm unit 2. The pump chamber 31 is engaged with the housing 24a so that the circumference portion 32a is fit into the hollow portion 26 of the housing 24a. Thereby, the pump chamber unit 1 and the diaphragm unit 2 are integrally joined and fixed, so that an elastic member 27 of the driving power transmission portion 2b in the diaphragm unit 2 is appressed to the driven membrane 33a of the pump chamber portion 3 by such fixation. The driven membrane 33a is deformed in conjunction with the driving power transmission portion 2b. Accordingly, when the diaphragm unit 2 and the pump chamber unit 1 are joined, the pump chamber 31 varies a capacity thereof by deformation of the bottom face thereof due to variation of the driven membrane 33a in conjunction with the driving power transmission portion 2b. By such variation of the capacity, the liquid in the pump chamber 31 is transferred to the discharge vent 5 so as to be electrostatically atomized.

In addition, the liquid container 4 is formed of an electric conductive container, and the discharge vent 5 is formed of an electric conductive material. Therefore, the liquid container 4 becomes the same potential as that of the housing 32 by connecting the liquid container 4 and the housing 32, and the discharge vent 5 becomes the same potential as that of the housing 32 by connecting the discharge vent 5 and the housing 32. In the pump chamber unit 1, the liquid container 4, the suction flow path 34a, the pump chamber 31, the discharge flow path 34b and the discharge vent 5 becomes the same potential electrically, because they are formed of electric conductive member and connected each other. In this way, since substantially entire flow paths 37 (shown by dotted line in FIG. 1) from the liquid container 4 to the discharge vent 5 of the pump chamber unit 1 becomes the same potential, the liquid contained in the entire flow paths 37 is maintained in the same potential. Thereby, no potential difference occurs in the flow paths 37 of the liquid, and thus, no electrolysis of the liquid or the like occurs.

The diaphragm driving portion 2a comprises a piezoelectric element (PZT) 21 which deforms due to voltage, an electrode layer 22 which transmits the control voltages to the piezoelectric element 21, a diaphragm sheet 23 which is deformed by the piezoelectric element 21, a tubular shaped housing 24 to which the diaphragm sheet 23 is fixed on an outer periphery by adhesion or welding, and an insulator film 25 which isolates the diaphragm unit 2 electrically from the pump chamber unit 1. The insulator film 25 has elasticity and driven following to the diaphragm sheet 23. In addition, the driving power transmission portion 2b comprises the housing 24a which has the cylindrical hollow portion 26 (having an inner diameter L1) which is engaged with the circumference portion 32a (having an outer diameter L2) of the pump chamber 31 of the housing 32, and the elastic member 27 having substantially circular shape at a bottom face side of the hollow portion 26. The housing 24a is fixed to the housing 24 via the insulator film 25 by an adhesive or the like, and outer periphery of the elastic member 27 is joined to periphery of the hollow portion 26 or the insulator film 25 by an adhesive or the like. In addition, the elastic member 27 has large elasticity, so that when joining the diaphragm unit 2 and the pump chamber unit 1, it is appressed to both of the insulator film 25 of the diaphragm driving portion 2a and the driven membrane 33a of the pump chamber 31 with no gap. Thereby, variation of the diaphragm sheet 23 of the diaphragm driving portion 2a can directly transmit to the driven membrane 33a of the pump chamber portion 3. In other words, when joining the diaphragm unit 2 and the pump chamber unit 1, the driven membrane 33a and the driving power transmission portion 2b can be appressed, so that the variation of the diaphragm driving portion 2a can effectively transmit to the pump chamber portion 3.

In this way, the variation of the diaphragm driving portion 2a is transmitted to the pump chamber portion 3 through the driving power transmission portion 2b, and thus, it varies the capacity of the pump chamber 31. Due to such variation of the capacity, the liquid stored in the liquid container 4 flows into the pump chamber 31 through the suction flow path 34a and the suction valve 35 as transferred fluid in suction process, and discharged to the discharge flow path 34b through the discharge valve 35b from the pump chamber 31 in discharge process, and transferred to the discharge vent 5. Such transferred liquid is electrostatically discharged from nozzles provided at front end of the discharge vent 5 due to electrostatic voltage E which is applied between the discharge vent 5 and the earth.

The configuration of the above mentioned diaphragm pump 10 is further explained in detail. In the diaphragm unit 2, the diaphragm sheet 23 is arranged to be embedded into the housing 24 in a manner so that a surface thereof becomes the same plane as the bottom face of the housing 24 which faces the pump chamber portion 3. In addition, the electrode layer 22 consists of an electrically conductive member which is formed on a surface of the flat piezoelectric element 21 by printing or the like, and the diaphragm sheet 23 consists of an electric conductive member which is appressed on the other surface of the piezoelectric element 21 to cover the surface entirely, so as to be elastically deformed corresponding to the deformation of the piezoelectric element 21. The housing 24 has a tubular shape and formed of a plastic material (for example, polyacetal (POM), poly carbonate (PC), polyphenylene sulfide (PPS) or the like). In addition, the insulator film 25 is appressed to and joined with the diaphragm sheet 23, and it is fixed on the housing 24 by an adhesive or the like so as to cover the housing 24 to which the diaphragm sheet 23 is fixed from the outside. As for a material of the insulator film 25, a fluorine resin film having a thickness 0.10 mm can be used, for example, but another material can be used corresponding to the voltage applied. Due to such insulator film 25, the electrostatic voltage E of the electric power source V which is applied to the liquid for electrostatic atomization in the pump chamber portion 3 is electrically insulated from the control voltages (VH and VL) for driving the diaphragm in the diaphragm unit 2, so that influence one another can be prevented. In addition, electrodes for applying voltage to the piezoelectric element 21 is established on the electrode layer 22 and the diaphragm sheet 23, respectively, and the control voltages (VH and VL) for driving the diaphragm is applied between these electrodes by a control circuit 6. Accordingly, when the control voltages are applied to the piezoelectric element 21 from the control circuit 6, the diaphragm sheet 23 varies due to deformation of the piezoelectric element 21, and thus, the insulator film 25 varies, simultaneously. Therefore, the diaphragm unit 2 can perform the diaphragm driving.

In the diaphragm driving portion 2a, the diaphragm sheet 23 is formed of a disc-shaped brass sheet, and measures of this brass sheet are a diameter of 20 mm and a thickness of 0.10 mm, and measures of the piezoelectric element 21 which is attached on the brass sheet are a diameter of 14 mm and a thickness of 0.13 mm. In addition, a voltage applied from the control circuit 6 is an alternating voltage of +120V and 0V, and when applying the voltage of +120V, the pump performs discharge process, and when applying the voltage of 0V, it performs suction process.

In the pump chamber portion 3, the suction valve 35a and the discharge valve 35b which are established in the vicinities of the pump chamber 31 of the suction flow path 34a and the discharge flow path 34b of the housing 32 are opened and closed due to directions of liquid flow and pressure differences. Structures of these suction valve 35a and discharge valve 35b are not limited in particular, but it is possible to use a cantilevered valve of rubber which is opened and closed due to the pressure difference between front and rear pressures of the valve, for example.

As for the electrical conductive material forming the housing 32, a PC, PPS, nylon resin, acryl resin or the like which contains carbon can be used other than metal. The driven membrane 33a, which seals the bottom of the pump chamber 31 in the side connected to the driving power transmission portion 2b, is formed of a very thin electric conductive resin so as to be deformed by driving of the diaphragm unit 2, and it serves as diaphragm operation in the side of the pump chamber 31 which works with the driving power transmission portion 2b. In addition, flow paths of liquid such as the pump chamber 31 and the liquid discharge flow path 34b of the housing 32 can be constitute of a material other than the electric conductive material for forming the driven membrane 33a, however, when forming these elements integrally in a member including the same material, process such as welding can be made easier.

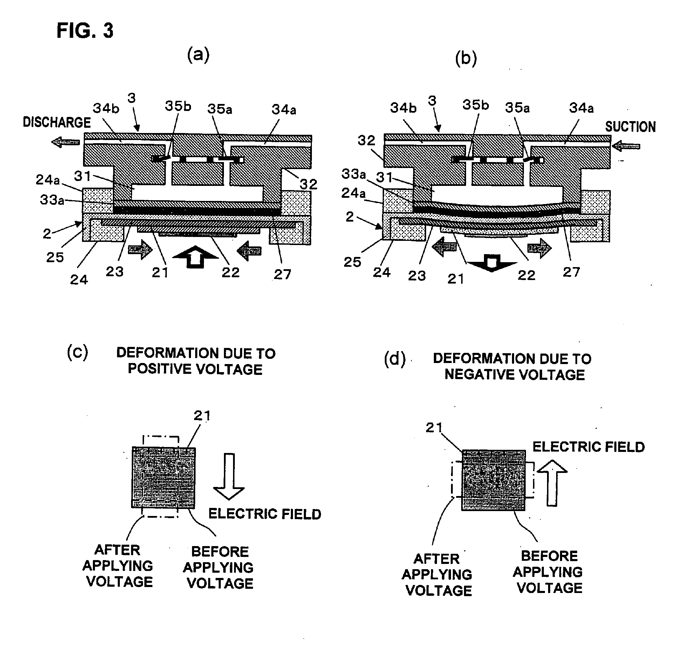

Operation of the above mentioned diaphragm pump 10 is described with reference to FIG. 3. FIG. 3(a) and FIG. 3(b) respectively show conditions of the diaphragm pump 10 in the suction process and the discharge process of the pump operation. FIG. 3(c) and FIG. 3(d) respectively show deformation conditions of the piezoelectric element 21 by applying positive voltage and negative voltage corresponding to the suction process and the discharge process. Hereupon, above and below in the figure designate thickness direction of the piezoelectric element 21 and the symbols + and - respectively designate polarization. When a voltage is applied between the electrode layer 22 and an electrode (not illustrated) provided on the diaphragm sheet 23, an electric field (which is illustrated by an outline arrow) occurs in the thickness direction of the piezoelectric element 21, and the piezoelectric element 21 deforms in the thickness direction and the radial direction thereof by such electric field. When the electric field occurs in the same direction as the direction of the polarization of the piezoelectric element 21 by applying positive voltage, the piezoelectric element 21 expands in the thickness direction and contracts in the radial direction as shown by vertically long rectangle illustrated by one dotted chain line. On the contrary, when the electric field occurs in the opposite direction to the direction of the polarization of the piezoelectric element 21 by applying negative voltage, the piezoelectric element 21 expands in the radial direction and contracts in the thickness direction as shown by horizontally long rectangle illustrated by one dotted chain line. Hereupon, in an initial state of the piezoelectric element 21 in the manufacturing process where no voltage is applied, the diaphragm sheet 23 is fixed on the housing 24 in a manner so that the pump chamber 31 is expanded.

When positive voltage is applied to the piezoelectric element 21 in the initial state with no voltage, the piezoelectric element 21 contracts in the radial direction but the diaphragm sheet 23 is not expanded, so that warp of the diaphragm sheet 23 is decreased due to the deformation of the piezoelectric element 21. Thereby, pressure in the pump chamber 31 is increased due to the capacity of the pump chamber 31 configured by the diaphragm sheet 23 and the housing 32 is decreased, so that the suction valve 35a is closed and the discharge valve 35b is opened, and the diaphragm pump 10 takes the discharge process to discharge the liquid from the discharge flow path 34b.

When the voltage applied to the piezoelectric element 21 is changed to grounding voltage from the above mentioned condition applying positive voltage, the diaphragm sheet 23 comes back to configuration of initial state by resilience of the diaphragm sheet 23 itself. In other words, when the capacity of the pump chamber 31 increases due to increasing of the warp of the diaphragm sheet 23, the pressure in the pump chamber 31 decreases, the discharge valve 35b closes and the suction valve 35a opens, and thus, the pump is given to transition to the suction process, so that the liquid is sucked through the suction flow path 34a. Applied voltage is assumed as alternating voltage of +120V and 0V, when applying +120V, the pump performs the discharge process, and when applying 0V, the pump performs suction process. In this way, the capacity of the space of the pump chamber 31 which is configured by the housing 32 and the driven membrane 33a varies when vibrations of the diaphragm sheet 23 due to the control voltage is transmitted to the insulator film 25, so that the pump operations of sucking and discharging are repeated.

The liquid discharged from the pump chamber 31 is discharged to the discharge vent 5 through the discharge flow path 34b. In the nozzle provided at the front end of the discharge vent 5, the liquid discharged from the pump chamber 31 becomes micro-particles and electrostatically atomized through the nozzle in the discharge vent 5 by applying high voltage of electrostatic voltage E between the discharge vent 5 and the earth. Hereupon, since the path from the pump chamber 31 to the discharge vent 5 is entirely formed of the electric conductive material, when the liquid flows, it is electrically conducted. Thus, the path of the liquid flow from the liquid container to the discharge vent 5 through the housing 32 which configures the pump chamber 31 becomes the same electric potential, so that the circumferences of the liquid flowing into the discharge vent from the pump chamber 31 are maintained in the same electric potential.

In this way, according to the diaphragm pump 10 of the first embodiment, since the liquid container 4, the suction flow path 34a, the pump chamber 31 and the discharge vent 5 are formed of the electric conductive material and the driven membrane 33a of the pump chamber 31 which cooperate with the driving power transmission portion 2b is formed of the electric conductive resin, the electric potential of the liquid flowing in the entire paths 37 from the liquid container 4 to the discharge vent 5 can be maintained in the same potential. Thereby, disincentive of the liquid flow due to isolation of liquid caused by internal electric field when potential difference exists in the flow path or generation of gas due to electrolysis can be removed, and thus, the discharged liquid can be electrostatically atomized smoothly without causing the reduction of the pump performance.

In addition, since the pump chamber unit 1 and the diaphragm unit 2 are detachable each other, it is possible to interchange the pump chamber portion 3 and the pump chamber unit 1 easily when the pump performance may be decreased due to pollution by the liquid. Moreover, since the bottom of the pump chamber 31 is closely sealed by the driven membrane 33a, when detaching the pump chamber unit 1 from the diaphragm unit 2, it is possible to prevent leakage of the liquid from the pump chamber 3, and it is possible to prevent intrusion of foreign matter such as dust into the pump chamber 31, simultaneously.

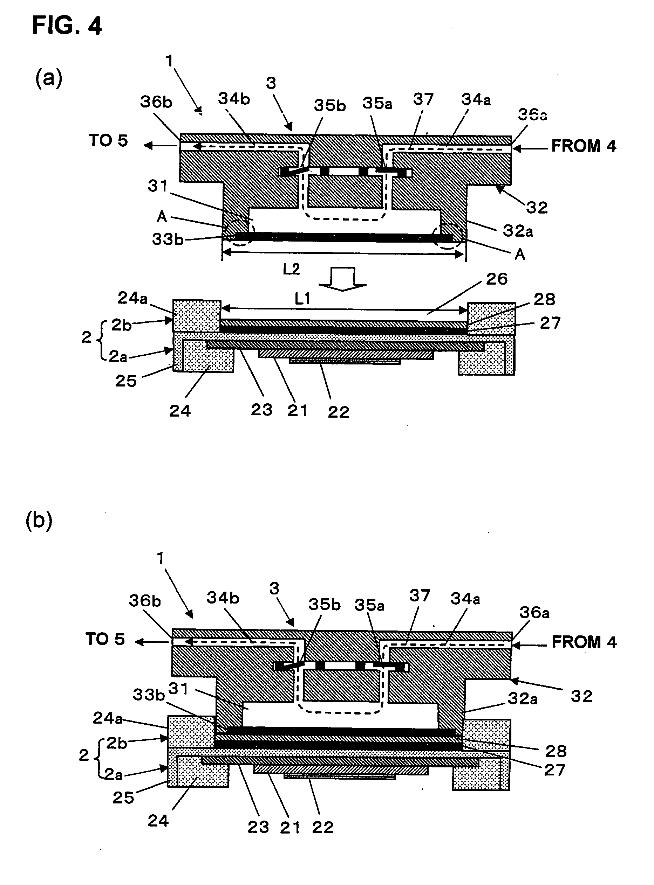

Subsequently, a diaphragm pump in accordance with a second embodiment which is realized the present invention is described with reference to FIG. 4(a) and FIG. 4(b). The second embodiment has substantially the same configuration as the above first embodiment, but differs at points that a face in the driving power transmission portion 2b contacting a driven membrane 33b is coated by an electric conductive material, and the driven member 33b is formed of a resin film.

In the diaphragm pump 10 of this embodiment, the driven membrane 33b which seals the bottom of the housing 32a of the pump chamber 31 (SIC) is formed of an insulation resin film, and the driving power transmission portion 2b has a metal foil 28 which is appressed to a surface of the elastic member 27 in the housing 24a by an adhesion or the like. In addition, the metal foil 28 is closely joined with the driven membrane 33b when the housing 32a of the pump chamber 31 and the housing 24a of the driving power transmission portion 2b are fitted to be coupled, and the metal foil 28 is joined by embedding with a bottom face of the housing 32a of the pump chamber 31 which is formed of an electric conductive material so that it is electrically connected with circumference on the bottom face of the pump chamber 31 as shown in an area "A" enclosed by a circle illustrated by broken line in FIG. 4(a). Thus, since the bottom face and the entire of the pump chamber 31 becomes the same potential, the pump chamber unit 1 entirely becomes the same potential, and thus, electric potentials the circumferences of the liquid flowing in the pump chamber unit 1 can be made even entirely.

According to the diaphragm pump 10 in this embodiment, even when the liquid in the pump chamber 31 has corrosion for metal, it is possible to reduce affect of corrosion to the driven membrane 33b by sealing the bottom of the pump chamber 31 by the driven membrane 33b of a resin film having high corrosion resistance, and thus, reliability of the pump chamber 31 can be increased. In addition, when coupling the pump chamber 31 and the driving power transmission portion 2b, the metal foil 28 of the driving power transmission portion 2b and the housing 32a of the pump chamber 31 made of an electric conductive material are electrically connected, so that entire of the bottom face of the pump chamber 31 can be made the same potential evenly. Accordingly, entire of the pump chamber unit 1 can be made the same potential, so that the liquid in the entire of the flow paths 37 in the pump chamber unit can be maintained in the same potential. Thereby, occurrence of defects such as electrolysis can be prevented, and smooth electrostatic atomization can be realized.

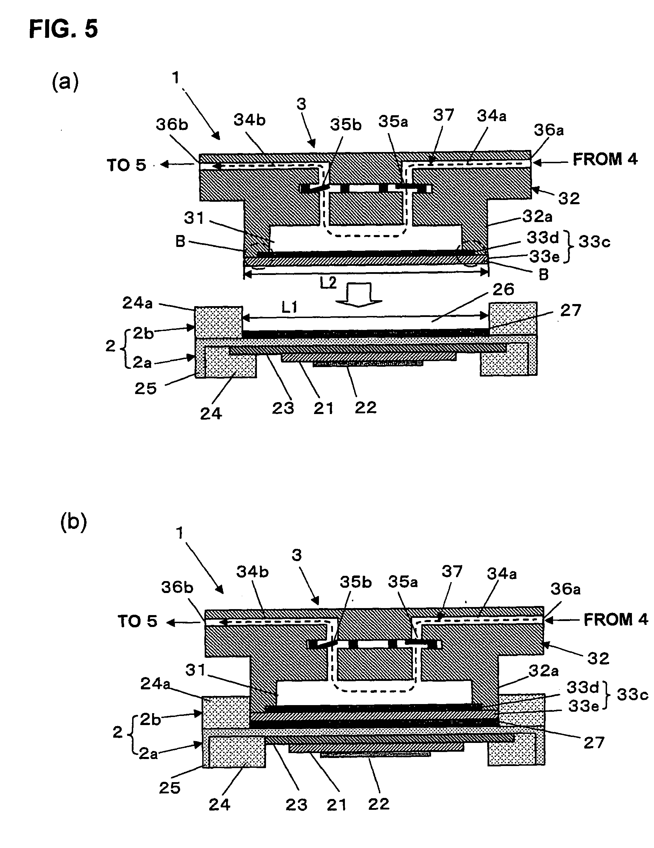

Subsequently, a diaphragm pump in accordance with a third embodiment which is realized the present invention is described with reference to FIG. 5(a) and FIG. 5(b). The third embodiment has substantially the same configuration as the above first embodiment, but differs at a point that a driven membrane 33c is a lamination film which is formed of a resin film 33d and an electric conductive film 33e appressed each other.

In the diaphragm pump 10 of this embodiment, the driven membrane 33c, which seals the bottom of the housing 32a of the pump chamber 31 (SIC), is formed of the lamination film of the resin film 33d and the electric conductive film 33e appressed each other. The driven membrane 33c of the lamination film is joined to the bottom face of the pump chamber 31 of the housing 32a by welding or the like, as shown in an area "B" enclosed by a circle illustrated by broken line in FIG. 5(a). In such welding, when the resin film 33d is formed of a plastic material, for example, the plastic material will be broken by heat in the welding, and the laminated metal foil intrude into the plastic material, and thus, the lamination film becomes electrically conductive from front face to rear face. Thereby, the driven membrane 33c can be electrically connected to the housing 32a of the pump chamber 31 by welding join. In addition, in the lamination of the resin film 33d and the electric conductive film 33e by welding joint, even when the driven membrane 33c is attached in a manner so that the resin film 33d made of an insulative material faces the liquid in the inside of the pump chamber 31, the driven membrane 33c and the housing 32a of the pump chamber 31 can be electrically connected, so that entire of the pump chamber 31 can be made the same electric potential and resistive to the corrosive liquid. Alternatively, when the liquid in the pump chamber 31 is not corrosive so much but air in outer circumference of the pump chamber 31 is corrosive, the driven membrane 33c can be made resistive to outer circumference by disposing the resin film 33d of the driven membrane 33c at the outside of the pump chamber 31. Moreover, since the driven membrane 33c is formed of the lamination film, mechanical strength of the membrane can be increased. Therefore, it is possible to laminate a thin electrically conductive film 33e on the resin film 33d having high driven performance.

According to the diaphragm pump 10 of this embodiment, since the driven membrane 33c is multilayered by forming as a lamination film of the resin film 33d and the electric conductive film 33e appressed each other, the mechanical strength of the driven membrane 33c is reinforced, and thus, the electric conductive material can be made much thinner, it can easily follow the variation from the driving power transmission portion 2b and efficiency of the driving power transmission from the diaphragm driving portion 2a can be increased. In addition, it is possible to be resistive to corrosion by disposing the resin film 33d of the driven member 33c in an inner side of the pump chamber to contact the liquid. Alternatively, when the liquid has little corrosion but air in the outer circumference has corrosion, it is possible to prevent the corrosion due to air by disposing the resin film 33d in the outside of the pump chamber. Moreover, the driven membrane 33c of the lamination film can be utilized the ready-made double-layered film of a resin film and a metal foil appressed each other, so that cost reduction can be realized.

According to the above mentioned diaphragm pump 10 in each embodiment, electric potential of the liquid flowing in the flow paths 37 from the liquid container 4 to the discharge vent 5 through the pump chamber 31 can be made even. Thereby, isolation of liquid due to internal electric field corresponding to potential difference in the flow path, generation of gas due to electrolysis or the like may not occur, so that discharged liquid can be electrostatically atomized smoothly without reduction of pump performance. In addition, since the pump chamber unit 1 and the diaphragm unit 2 are detachably attached, the pump chamber portion 3 or the pump chamber unit 1 can easily be interchanged when the pump performance is reduced by pollution due to the liquid. Moreover, since the bottom of the pump chamber 31 is closely sealed by the driven membrane 33a, when detaching the pump chamber unit 1 from the diaphragm unit 2, it is possible to prevent leakage of the liquid from the pump chamber 3, and it is possible to prevent intrusion of foreign matter such as dust into the pump chamber 31, simultaneously.

The present invention is not limited to above mentioned embodiments, and can be transformed in various manners. For example, even when the pump chamber unit is not formed of an electric conductive material entirely, it is preferable that outer walls of the pump chamber is formed of an electric conductive material and the pump chamber unit is entirely the same potential so as to be at least the liquid in the pump chamber becomes the same potential. In addition, although the housing of the pump chamber portion is formed the pump chamber, suction valve/discharge valve, suction flow path, and discharge flow path integrally, it is possible to constitute the pump chamber detachable from the flow paths.

This application is based on Japanese patent application 2006-201439, the contents of which are hereby incorporated by references.

Although the present invention has been fully described by way of example with reference to the accompanying drawings, it is to be understood that various changes and modifications will be apparent to those skilled in the art. Therefore, unless otherwise such changes and modifications depart from the scope of the present invention, they should be construed as being included therein.

## Claims

1. A diaphragm pump for transferring liquid to electrostatically atomize the liquid, comprising a piezoelectric element, a diaphragm which is deformed by the piezoelectric element, and a pump chamber that varies a capacity thereof in conjunction with the diaphragm and performs suction and discharge of the liquid due to variation of the capacity, wherein
the diaphragm and the pump chamber are detachably attached each other;
the diaphragm comprises a driving power transmission portion to transmit deformation of the piezoelectric element to the pump chamber;
the pump chamber comprises
a driven membrane which is in conjunction with the driving power transmission portion,
a liquid container which is deformed via the driven membrane and supplies liquid to the pump chamber,
a first flow path which couples the liquid container and the pump chamber,
a discharge vent from which the liquid from the liquid container is discharged, and
a second flow path which couples the discharge vent and the pump chamber; and wherein
when the diaphragm and the pump chamber are coupled, at least the liquid container, the first flow path, the pump chamber, the second flow path and the discharge vent are electrically connected to be the same potential.

2. The diaphragm pump in accordance with claim 1, wherein
a face of the driving power transmission unit which contacts the driven membrane is coated by an electric conductive material, and the driven membrane is formed of a resin material.

3. The diaphragm pump in accordance with claim 1, wherein
the driven membrane has a lamination film of a resin film and an electric conductive film appressed each other.
